# EUROPEAN PATENT SPECIFICATION

(11) **EP 4 286 209 B1**
(45) Date of publication and mention of the grant of the patent: **14.10.2026**
(21) Application number: 23175277.5
(22) Date of filing: 25.05.2023
(51) Int. Cl.: B60L 50/50, B60L 50/60, B60L 53/62, B60L 58/10, B60L 58/12, H02J 7/34

(54) **POWER REPLENISHMENT WAKE-UP APPARATUS AND METHOD FOR LOW-VOLTAGE BATTERY**
STROMAUFFÜLLUNGSAUFWECKVORRICHTUNG UND VERFAHREN FÜR NIEDERSPANNUNGSBATTERIE
APPAREIL ET PROCÉDÉ DE RÉVEIL DE RÉAPPROVISIONNEMENT EN ÉNERGIE POUR BATTERIE BASSE TENSION

(30) Priority: 26.05.2022 CN 202210580630
(43) Date of publication of application: 06.12.2023
(73) Proprietor: Nio Technology (Anhui) Co., Ltd, Hefei City, Anhui 230601 (CN)
(72) Inventor: CHEN, Ming, Hefei, Anhui, 230601 (CN); XIAO, Bohong, Hefei, Anhui, 230601 (CN); LUO, Wu, Hefei, Anhui, 230601 (CN); YAN, Zhujun, Hefei, Anhui, 230601 (CN); ZHU, Yuhong, Hefei, Anhui, 230601 (CN)
(74) Representative: Vossius & Partner Patentanwälte Rechtsanwälte mbB

(56) References cited:
- US-A1- 2018 134 176
- US-A1- 2019 176 638
- US-A1- 2022 029 429

## Description

### Technical Field

The disclosure relates to the technical field of vehicle batteries, and in particular, to a power replenishment wake-up apparatus and method for a low-voltage battery.

### Background Art

A low-voltage battery of a vehicle is usually a 12V battery. Currently, a new energy vehicle has different requirements for a low-voltage battery from those of a traditional fuel vehicle for a low-voltage battery. The traditional fuel vehicle has a large start-up current of 130A with an extremely short time, and has a low quiescent current in a sleep mode, in which case few amount of electric energy of a low-voltage battery is consumed, and the low-voltage battery rarely operates independently. In contrast, a new energy vehicle has a small start-up current, for example, approximately 35 A. However, the new energy vehicle requires the use of a low-voltage battery to quickly respond to remote vehicle control and monitor a high-voltage lithium battery, and independently supplies energy required for the vehicle when battery swapping and over-the-air (OTA) upgrade of a traction battery are completed, thus requiring a high quiescent current in a sleep mode, which is also harmful to the low-voltage battery.

US2018/134176A1 discloses a power replenishment wake-up apparatus.

### Summary

The present invention is set out in the independent claims whereas preferred embodiments and further implementations are outlined in the dependent claims, description and figures.

### Brief Description of the Drawings

The above and other objectives and advantages of the disclosure will be more thorough and clearer from the following detailed description in conjunction with the accompanying drawings, where the same or similar elements are represented by the same reference numerals.
FIG. 1 shows a vehicle according to an embodiment of the disclosure;
FIG. 2 shows a power replenishment wake-up apparatus according to an embodiment of the disclosure; and
FIG. 3 shows a power replenishment wake-up method according to an embodiment of the disclosure.

### Detailed Description of Embodiments

The invention is defined by the appended claims. The power replenishment wake-up apparatus and the power replenishment wake-up method involved in the disclosure will be described in further detail below in conjunction with the accompanying drawings. It should be noted that the following detailed description of embodiments is exemplary rather than limiting, and is intended to provide a basic understanding of the disclosure, and is not intended to confirm key or decisive elements of the disclosure or limit the scope of protection.

The disclosure is described below with reference to the block diagram descriptions, the block diagrams, and/or the flowcharts of the methods and apparatuses in the embodiments of the disclosure. It will be understood that each block of these flowchart descriptions and/or the block diagrams, and combinations of the flowchart descriptions and/or the block diagrams, can be implemented by computer program instructions. These computer program instructions may be provided for a processor of a general-purpose computer, a dedicated computer, or a further programmable data processing device to generate a machine, so that the instructions executed by the processor of the computer or the further programmable data processing device create components for implementing the functions/operations specified in these flowcharts and/or blocks and/or one or more flow block diagrams.

These computer program instructions may be stored in a computer-readable memory, and the instructions can instruct a computer or another programmable processor to implement the functions in a specific manner, so that the instructions stored in the computer-readable memory generate a manufactured product containing instruction components that implement the functions/operations specified in one or more blocks of the flowcharts and/or the block diagrams.

These computer program instructions may be loaded onto the computer or the further programmable data processor, so that a series of operations and steps are performed on the computer or the further programmable processor, to generate a computer-implemented process. As such, the instructions executed on the computer or the further programmable data processor provide steps for implementing the functions or operations specified in one or more blocks in the flowcharts and/or block diagrams. It should also be noted that in some alternative implementations, the functions/operations shown in the blocks may not occur in the order shown in the flowcharts. For example, two blocks shown in sequence may actually be executed substantially simultaneously or the blocks may sometimes be executed in a reverse order, depending on the functions/operations involved.

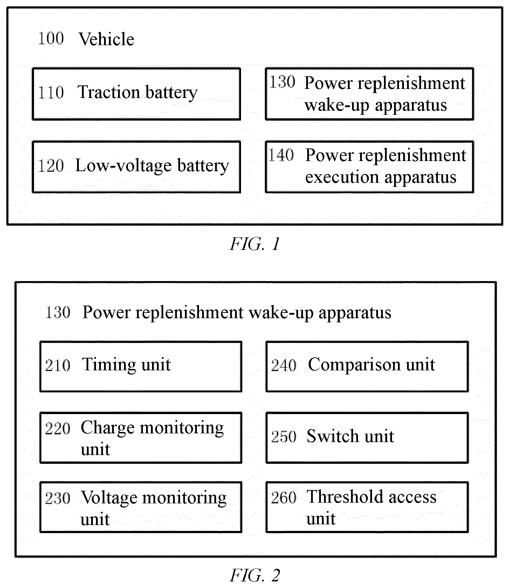

A vehicle 100 according to an implementation of the disclosure will be described below in conjunction with FIG. 1.

FIG. 1 shows the vehicle 100 according to an embodiment of the disclosure. In the embodiments of the disclosure, the vehicle 100 is a new energy vehicle, a hybrid vehicle, or a battery electric vehicle, and in other embodiments, the vehicle 100 may also be other types of vehicles. As shown in FIG. 1, the vehicle 100 includes a traction battery 110, a low-voltage battery 120, a power replenishment wake-up apparatus 130, and a power replenishment execution apparatus 140. The traction battery 110 is configured to provide a power source for the vehicle 100. The low-voltage battery 120 is configured to provide energy to meet requirements for electricity, other than power, of the vehicle 100. The power replenishment wake-up apparatus 130 is configured to send a power replenishment wake-up signal to the power replenishment execution apparatus 140 when power replenishment is required for the low-voltage battery 120. The power replenishment execution apparatus 140 is configured to perform an action of replenishing the low-voltage battery 120 with power upon receiving the power replenishment wake-up signal.

In this embodiment, the traction battery 110 is a high-voltage lithium battery, and in other embodiments, the traction battery 110 may also be other types of batteries. In this embodiment, the low-voltage battery 120 may be configured to provide energy for wake-up, startup, monitoring of the traction battery 110, a rapid response to remote vehicle control, and other operations of the vehicle 100. In addition, the low-voltage battery 120 can also independently supply energy required for the vehicle when battery swapping and over-the-air (OTA) upgrade of the traction battery 110 are completed. In some embodiments, the low-voltage battery 120 is a 12V lithium iron phosphate (LFP) battery. The 12V LFP battery includes a plurality of cells, for example, two, three, four cells, etc. In other embodiments, the low-voltage battery 120 may also be other types of batteries.

Because the new energy vehicle requires a high quiescent current in a sleep mode, the power replenishment wake-up apparatus 130 is provided in the vehicle 100 in the disclosure, in order to avoid the phenomenon that the vehicle 100 cannot be started normally and to ensure normal implementation of other functions of the vehicle 100. The power replenishment wake-up apparatus 130 monitors a trigger condition for determining whether power replenishment is required for the low-voltage battery 120 when the vehicle is in a sleep mode, and wakes up the power replenishment execution apparatus 140 to perform a power replenishment action when power replenishment is required for the low-voltage battery 120.

In the embodiments of the disclosure, the power replenishment wake-up apparatus 130 is communicatively connected to the low-voltage battery 120, such that the power replenishment wake-up apparatus 130 can monitor the low-voltage battery 120. In addition, the power replenishment wake-up apparatus 130 is further communicatively connected to the power replenishment execution apparatus 140, such that when power replenishment is required for the low-voltage battery 120, the power replenishment wake-up apparatus 130 can send, to the power replenishment execution apparatus 140, a wake-up signal to perform an action of power replenishment.

In the embodiments of the disclosure, the power replenishment execution apparatus 140 includes a direct current-direct current (DC-DC) converter. Through a DC-DC conversion function, the power replenishment execution apparatus 140 can charge the low-voltage battery 120 by using the traction battery 110 at a high voltage, thereby implementing a power replenishment function of the power replenishment execution apparatus 140.

The power replenishment wake-up apparatus 130 according to an implementation of the disclosure will be described below in conjunction with FIG. 2.

FIG. 2 is a schematic diagram of the power replenishment wake-up apparatus 130 according to an embodiment of the disclosure. As shown in FIG. 2, the power replenishment wake-up apparatus 130 includes a timing unit 210, a charge monitoring unit 220, a voltage monitoring unit 230, a comparison unit 240, a switch unit 250, and a threshold access unit 260. The comparison unit 240 is communicatively connected to the timing unit 210, the charge monitoring unit 220, the voltage monitoring unit 230, and the threshold access unit 260, respectively, and the switch unit 250 is communicatively connected to the timing unit 210, the charge monitoring unit 220, and the voltage monitoring unit 230, respectively.

In this embodiment, the timing unit 210 is configured to: start timing when the vehicle 100 enters a vehicle sleep state, and transmit an accumulated time for the vehicle 100 in the vehicle sleep state to the comparison unit in real time. The charge monitoring unit 220 is configured to monitor a state of charge of the low-voltage battery 120, and transmit a value of the state of charge of the low-voltage battery 120 to the comparison unit in real time. The voltage monitoring unit 230 is configured to monitor a voltage of the low-voltage battery 120, and transmit a value of the voltage of the low-voltage battery 120 to the comparison unit in real time.

The comparison unit 240 is configured to: compare a value of a counted time received from the timing unit 210 with a first time threshold, compare a value of the state of charge received from the charge monitoring unit 220 with a charge threshold, compare a value of the voltage received from the voltage monitoring unit 230 with a voltage threshold, and send a wake-up signal for power replenishment of the low-voltage battery 120 to the power replenishment execution apparatus 140 when the value of the time is greater than the first time threshold, and/or the value of the state of charge is less than the charge threshold, and/or the value of the voltage is less than the voltage threshold for a second time threshold. In other words, the value of the accumulated time for which the vehicle 100 has been in the vehicle sleep state being greater than the first time threshold, the value of the state of charge of the low-voltage battery 120 being less than the charge threshold, and the value of the voltage of the low-voltage battery 120 being less than the voltage threshold for a second time threshold are three trigger conditions for determining whether power replenishment is required for the low-voltage battery 120. The power replenishment wake-up apparatus 130 in the disclosure can simultaneously monitor three different dimensions, namely, the accumulated vehicle sleep time, the state of charge of the low-voltage battery 120, and the voltage of the low-voltage battery 120, to determine whether the low-voltage battery 120 currently needs to be charged. This fully considers all aspects for good operating performance of the low-voltage battery 120, thereby effectively ensuring the operating capability of the low-voltage battery 120 while the vehicle is in the sleep state.

The threshold access unit 260 is configured to: store the charge threshold, the voltage threshold, and the first time threshold, and receive modifications to the charge threshold, the voltage threshold, and the first time threshold. A user or a maintenance provider can set and modify the charge threshold, the voltage threshold, and the first time threshold, which are stored in the threshold access unit 260, based on current environmental conditions or individual demands, and provide these thresholds to the comparison unit 240 when necessary, such that the comparison unit 240 performs a corresponding threshold comparison and determination.

The switch unit 250 is configured to be able to selectively turn on or off one or more of the charge monitoring unit 220, the voltage monitoring unit 220, and the timing unit 210. The switch unit 250 is provided such that the user can select, as needed, a trigger condition for determining whether power replenishment is required for the low-voltage battery 120, and the configuration of the power replenishment wake-up apparatus 130 can thus be more adapted to the individual demands of the user. For example, in some embodiments, if the vehicle 100 needs to be in a sleep state for a long time (for example, when the user would travel and then leave the vehicle unused for a long time), the user may turn off the charge monitoring unit 220 and the voltage monitoring unit 220 and only turn on the timing unit 210 by using the switch unit 250, to determine whether power replenishment is required for the low-voltage battery 120 through time monitoring. In this case, the accumulated time for which the vehicle 100 has been in a vehicle sleep state is the only condition that triggers power replenishment of the low-voltage battery 120. In this state, it is not only ensured that the low-voltage battery 120 is kept at a good charge level, but also it is conductive to reducing the energy consumption of the vehicle 100 when being in the sleep state for a long time. In some other embodiments, the user may also simultaneously turn on the charge monitoring unit 220, the voltage monitoring unit 220, and the timing unit 210, to determine whether power replenishment is required for the low-voltage battery 120 by monitoring the accumulated time for which the vehicle 100 has been in the sleep state, and the current state of charge and the current voltage of the low-voltage battery 120.

In the embodiments of the disclosure, the power replenishment wake-up apparatus 130 includes the switch unit 250 to adapt to various usage scenarios of the vehicle 100 by the user. In other embodiments, the power replenishment wake-up apparatus 130 may also not include a switch unit 250, in which case the power replenishment wake-up apparatus 130 no longer configures a monitoring condition depending on the user's demands, but directly determines whether power replenishment is required for the low-voltage battery 120 based on all of monitored values from the charge monitoring unit 220, the voltage monitoring unit 220, and the timing unit 210.

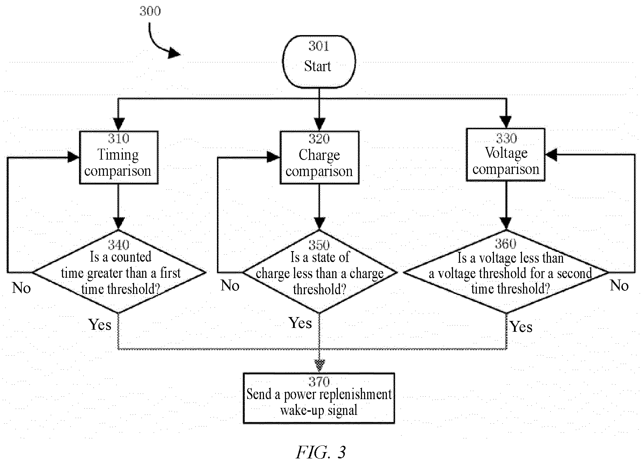

The power replenishment wake-up method 300 according to an implementation of the disclosure will be described below in conjunction with FIG. 3.

FIG. 3 is a schematic diagram of the power replenishment wake-up method 300 according to an embodiment of the disclosure. Because the 12 V low-voltage battery 120 of the new energy vehicle has a characteristic of a high quiescent current consumption in a vehicle sleep mode, the power replenishment wake-up apparatus 130 is provided in the vehicle 100 in the disclosure. The power replenishment wake-up apparatus 130 can simultaneously monitor three trigger conditions for power replenishment of the low-voltage battery 120, and send a wake-up signal for power replenishment of the low-voltage battery 120 to the power replenishment execution apparatus 140 when it is determined that any one of the trigger conditions for power replenishment is satisfied.

As shown in FIG. 3, the power replenishment wake-up method 300 starts with step 301. Optionally, when it is detected that the vehicle enters a sleep state and it is determined that the low-voltage battery 120 has not failed, the power replenishment wake-up apparatus 130 performs the start step 301 to execute the power replenishment wake-up method 300. In some embodiments, it can be determined whether the low-voltage battery 120 has failed by detecting whether a Mosfet is switched off. If it is detected that the Mosfet is not switched off, it is determined that the low-voltage battery 120 has not failed, that is, one condition for performing the power replenishment wake-up method 300 is satisfied. If it is detected that the Mosfet is switched off, it is determined that the low-voltage battery 120 has failed. In this case, it is necessary to repair or change the low-voltage battery 120, and the power replenishment wake-up method 300 in the disclosure is not performed.

The power replenishment wake-up method 300 can make it possible to determine whether power replenishment is required for the low-voltage battery 120 by simultaneously monitoring the three trigger conditions, and send a power replenishment wake-up signal upon determining that power replenishment is required for the low-voltage battery 120. The determination based on the three trigger conditions includes determination based on a vehicle sleep time, a state of charge, and a voltage. The determination based on the three trigger conditions fully considers various situations in which the low-voltage battery 120 is drained, and the determination is made based on the three trigger conditions that are tightly coupled, which can ensure that the low-voltage battery 120 is kept at a good charge level in several ways.

The steps of determination as to whether power replenishment is required for the low-voltage battery 120 based on the three trigger conditions will be specifically described below according to the embodiments of the disclosure.

The steps of determination based on the vehicle sleep time include steps 310 and 340. In step 310, the timing unit 210 and the comparison unit 240 cooperate to perform timing comparison. The timing comparison includes as follows: when the vehicle 100 enters a vehicle sleep state, the timing unit 210 starts timing, and the comparison unit 240 obtains a value of a counted time from the timing unit 210 and the first time threshold stored in the threshold access unit 260, and compares the value of the time with the first time threshold.

The first time threshold may be directly stored, as a fixed value, in the threshold access unit 260 through factory settings, or may be modified by a user or maintenance provider based on performance of the low-voltage battery 120 itself and/or external environmental conditions (for example, temperature) and then stored in the threshold access unit 260. Optionally, the first time threshold ranges from 1h to 72h. In the embodiments of the disclosure, the first time threshold is 12h.

In step 340, the comparison unit 240 further determines whether the value of the counted time is greater than the first time threshold. If yes (that is, when it is determined that the time value is greater than the first time threshold), step 370 is performed. If not (that is, when it is determined that the time value is less than or equal to the first time threshold), return to step 310 to perform the timing comparison again. In other words, in the embodiments of the disclosure, if the vehicle sleep time > 12h, step 370 is performed.

The steps of determination based on the state of charge include steps 320 and 350. In step 320, the charge monitoring unit 220 and the comparison unit 240 cooperate to perform charge comparison. The charge comparison includes as follows: the charge monitoring unit 220 monitors a state of charge of the low-voltage battery 120, and the comparison unit 240 obtains a value of the state of charge monitored by the charge monitoring unit 220 and the charge threshold stored in the threshold access unit 260, and compares the value of the state of charge with the charge threshold.

The charge threshold may be directly stored, as a fixed value, in the threshold access unit 260 through factory settings, or may be modified by a user or maintenance provider based on performance of the low-voltage battery 120 itself and/or external environmental conditions (for example, temperature) and then stored in the threshold access unit 260. Optionally, the charge threshold ranges from 50%-70%. In the embodiments of the disclosure, the charge threshold is 60%.

In step 350, the comparison unit 240 further determines whether the value of the state of charge is less than the charge threshold. If yes (that is, when it is determined that the value of the state of charge is greater than the first time threshold), step 370 is performed. If not (that is, when it is determined that the value of the state of charge is greater than or equal to the charge threshold), the comparison unit returns to step 320 to perform the charge comparison again. In other words, if the state of charge (SOC) < 60% after discharge, step 370 is performed.

The steps of determination based on the voltage include steps 330 and 360. In step 330, the voltage monitoring unit 230 and the comparison unit 240 cooperate to perform voltage comparison. The voltage comparison includes as follows: the voltage monitoring unit 230 monitors a voltage of the low-voltage battery 120, and the comparison unit 240 obtains a value of the voltage monitored by the voltage monitoring unit 230 and the voltage threshold stored in the threshold access unit 260, and compares the value of the voltage with the voltage threshold. In the embodiments of the disclosure, if the low-voltage battery 120 is a 12V LFP battery composed of three cells, the voltage monitoring unit 230 can monitor voltages of all of the three cells, and the comparison unit 240 can respectively compare values of the monitored voltages of all the cells with the voltage threshold.

The voltage threshold may be directly stored, as a fixed value, in the threshold access unit 260 through factory settings, or may be customized and modified by a user or maintenance provider and stored in the threshold access unit 260. Optionally, the voltage threshold ranges from 3.1 V to 3.4 V. In the embodiments of the disclosure, the voltage threshold is 3.23 V.

In step 360, the comparison unit 240 further determines whether the value of the voltage is less than the voltage threshold for the second time threshold. If yes (that is, if the value of the voltage is less than the voltage threshold for the second time threshold), step 370 is performed. If not (that is, if none of the values of the voltages is less than the voltage threshold for the second time threshold), the comparison unit returns to step 330 to perform the voltage comparison again.

Setting a duration for the second time threshold can prevent the occurrence of an error in determining the voltage of the low-voltage battery 120 due to an unstable instantaneous voltage of the low-voltage battery 120. Optionally, the second time threshold is a fixed value stored in determination logic of the comparison unit 240. In some embodiments, the second time threshold ranges from 0 to 10 seconds. In this embodiment, the second time threshold is 2 seconds. It should be noted that the second time threshold may be a value of 0. That is to say, in some embodiments, as a basis for voltage determination, the value of the voltage of the low-voltage battery 120 can be directly compared with the voltage threshold in step 360, regardless of the duration of the value of the voltage. In other words, in an embodiment in which the second time threshold is a value of 0, the steps of voltage determination do not consider the factor that an error occurs in determining the voltage of the low-voltage battery 120 due to an unstable instantaneous voltage of the low-voltage battery 120.

In the embodiments of the disclosure, corresponding to monitoring of the 12 V low-voltage battery 120 composed of three cells, the comparison unit 240 can determine whether one of the respective values of the voltages of the three cells is less than 3.23 V for 2s. If the value of the voltage of any cell is less than 3.23 V for 2s, step 370 is performed. If none of the values of the voltages of the three cells is less than 3.23 V for 2s, the comparison unit returns to step 330 to perform voltage comparison on all of the three cells again.

In step 370, the comparison unit 370 sends a power replenishment wake-up signal to the power replenishment execution apparatus 140. For example, if the sleep time of the vehicle 100 > 12h, the comparison unit 240 sends a signal for requesting power replenishment to the power replenishment execution apparatus 140 because of an excessively long sleep time of the vehicle 100. If the state of charge (SOC) < 60% after discharge, the comparison unit 240 sends a signal for requesting power replenishment to the power replenishment execution apparatus 140 because of an excessively low SOC. If the value of the voltage of any cell is less than 3.23 V for 2s, the comparison unit 240 sends a signal for requesting power replenishment to the power replenishment execution apparatus 140 because of an excessively low voltage value. The power replenishment execution apparatus 140 that has received the power replenishment signal can perform a charging task as requested, for example, allow the traction battery 110 to perform a charging operation on the low-voltage battery 120.

Through the power replenishment wake-up method 300 of this embodiment, it is determined, based on all the three trigger conditions, whether an action of charging the low-voltage battery 120 needs to be awakened. A wake-up signal for power replenishment of the low-voltage battery 120 can be sent provided that it is determined, based on one trigger condition, that the low-voltage battery 120 needs to be charged. In other embodiments, any one or two conditions of the vehicle sleep time vehicle, the state of charge, and the voltage may also be selected according to user demands, to determine whether the low-voltage battery 120 needs to be charged. For example, only the vehicle sleep time may be selected as a trigger condition for determining whether the low-voltage battery 120 needs to be charged, or a combination of both the vehicle sleep time and the state of charge may be selected as a trigger condition for determining whether the low-voltage battery 120 needs to be charged, or a combination of both the vehicle sleep time and the voltage may be selected as a trigger condition for determining whether the low-voltage battery 120 needs to be charged.

Another aspect of the disclosure further includes a computer storage medium including instructions, where when the instructions are run, the power replenishment wake-up method 300 as described above in the disclosure is performed.

The disclosure provides a strategy for monitoring a low-voltage LFP battery when an electric vehicle is in a sleep mode and determining whether to wake up a traction battery to replenish the low-voltage battery with power, to achieve a goal that the low-voltage LFP battery can still be kept at a good charge level when being in a sleep mode for a long time. Module units involved in this strategy include: the timing unit 210, the charge monitoring unit 220, the voltage monitoring unit 230, and the comparison unit 240. When the electric vehicle enters a sleep state and it is detected that the low-voltage battery 120 has not failed, the power replenishment wake-up apparatus 130 is enabled, such that when the timing unit 210, the charge monitoring unit 220, the voltage monitoring unit 230, and the comparison unit 240 cooperate to detect that the voltage of the low-voltage battery 120 is less than the voltage threshold, the SOC is less than the charge threshold, and the counted time exceeds the first time threshold for a set sleep time, the power replenishment wake-up apparatus sends a corresponding wake-up signal to the power replenishment execution apparatus 140 to allow the traction battery to replenish the low-voltage battery with power.

The 12 V low-voltage battery of the new energy vehicle needs to be awakened and replenished with power due to its high quiescent current consumption in a vehicle sleep mode. In the disclosure, the low-voltage LFP battery is monitored when the electric vehicle is in a sleep mode, and then a strategy module is controlled to determine whether to wake up the traction battery to replenish the low-voltage battery with power, such that the low-voltage LFP battery can still be kept at a good charge level when being in a sleep mode for a long time, thereby preventing the electric vehicle from failing to start normally after being in a sleep mode for a long time. The wake-up strategy in the disclosure fully considers various situations in which drainage occurs, and the trigger conditions for wake-up are tightly coupled, which can ensure that a function of charging wake-up of the low-voltage battery is not disabled in several ways.

Three trigger conditions are set in the wake-up strategy of the disclosure. When it is detected that the vehicle enters a sleep mode and the low-voltage battery has not failed (for example, the Mosfet is not switched off), a wake-up function of the power replenishment wake-up apparatus 130 is enabled, and in the vehicle sleep state, related voltage and SOC detection functions remain in operation. In this case, if it is detected that the voltage of the low-voltage battery is less than the voltage threshold or the SOC is less than the charge threshold, or the sleep time exceeds the first time threshold, the power replenishment wake-up apparatus 130 wakes up the traction battery to replenish the low-voltage battery with power.

Optionally, after the vehicle enters a sleep mode, a sleep state signal and a Mosfet signal are sent, through a bus, to the power replenishment wake-up apparatus 130 for the low-voltage battery 120, to enable the power replenishment wake-up apparatus, and at this time, the timing unit 210 starts timing and receives a voltage signal and an SOC signal from the low-voltage LFP battery. If the voltage of the low-voltage LFP battery < 3 .23V for two seconds, the power replenishment wake-up apparatus sends a signal for requesting power replenishment in the case of an excessively low voltage. If the SOC of the low-voltage LFP battery < 60% after discharge, the power replenishment wake-up apparatus sends a signal for requesting power replenishment in the case of an excessively low SOC. If the vehicle sleep time > 72h, the power replenishment wake-up apparatus sends a signal for requesting power replenishment in the case of an excessively long vehicle sleep time.

## Claims

1. A power replenishment wake-up apparatus (130) for a low-voltage battery (120), the low-voltage battery (120) being applied to a vehicle (100), wherein the power replenishment wake-up apparatus (130) comprises:
a timing unit (210), the timing unit (210) being configured to: start timing when the vehicle (100) enters a vehicle sleep state;
a charge monitoring unit (220), the charge monitoring unit (220) being configured to monitor a state of charge of the low-voltage battery (120);
a voltage monitoring unit (230), the voltage monitoring unit (230) being configured to monitor a voltage of the low-voltage battery (120); and
a comparison unit (240), wherein the comparison unit (240) is communicatively connected to the timing unit (210), the charge monitoring unit (220), and the voltage monitoring unit (230), respectively, and the comparison unit (240) is configured to:
receive, from the timing unit (210), a value of a counted time indicating a value of accumulated time for which the vehicle (100) has been in the vehicle sleep state, and compare the value of the time with a first time threshold;
receive a value of the state of charge from the charge monitoring unit (220), and compare the value of the state of charge with a charge threshold;
receive a value of the voltage from the voltage monitoring unit (230), and compare the value of the voltage with a voltage threshold; and
send a wake-up signal for power replenishment of the low-voltage battery (120) when the following comparison results are satisfied: the time value being greater than the first time threshold, the value of the state of charge being less than the charge threshold, and the value of the voltage being less than the voltage threshold for a second time threshold.

2. The power replenishment wake-up apparatus (130) according to claim 1, wherein the power replenishment wake-up apparatus (130) further comprises:
a switch unit (250), the switch unit (250) being configured to be able to selectively turn on or off one or more of the following: the charge monitoring unit (220), the voltage monitoring unit (220), and the timing unit (210).

3. The power replenishment wake-up apparatus (130) according to any one of claim 1 to 2, wherein
the second time threshold ranges from 0 to 10 seconds.

4. The power replenishment wake-up apparatus (130) according to any one of claims 1 to 3, wherein
the low-voltage battery (120) is a lithium iron phosphate battery.

5. The power replenishment wake-up apparatus (130) according to any one of claims 1 to 4, wherein
the low-voltage battery (120) comprises a plurality of cells, the voltage monitoring unit (230) is further configured to monitor voltages of all of the plurality of cells, and the comparison unit (240) is further configured to: upon receiving, from the voltage monitoring unit (230), the monitored voltages of all of the plurality of cells, respectively compare values of the voltages of all of the plurality of cells with the voltage threshold; and send a wake-up signal for power replenishment of the low-voltage battery (120) when at least one of the values of the voltages of all of the plurality of cells is less than the voltage threshold for a second time threshold.

6. The power replenishment wake-up apparatus (130) according to any one of claims 1 to 5, wherein
the charge threshold ranges from 50% to 70%, and the first time threshold ranges from 1h to 72h.

7. The power replenishment wake-up apparatus (130) according to any one of claims 1 to 6, wherein the power replenishment wake-up apparatus (130) further comprises:
a threshold access unit (260), wherein the threshold access unit (260) is communicatively connected to the comparison unit (240), and the threshold access unit (260) is configured to: store the charge threshold, the voltage threshold, and the first time threshold, and receive modifications to the charge threshold, the voltage threshold, and the first time threshold.

8. A power replenishment wake-up method (300) for a low-voltage battery (120), the low-voltage battery (120) being mounted on a vehicle (100), wherein the power replenishment wake-up method (300) comprises:
performing timing comparison (310), charge comparison (320), and voltage comparison (330), wherein
the timing comparison (310) comprises: starting timing when the vehicle (100) enters a vehicle sleep state, and comparing a value of a counted time indicating a value of accumulated time for which the vehicle (100) has been in the vehicle sleep state with a first time threshold;
the charge comparison (320) comprises: monitoring a state of charge of the low-voltage battery (120), and comparing a value of the monitored state of charge with a charge threshold; and
the voltage comparison (330) comprises: monitoring a voltage of the low-voltage battery (120), and comparing a value of the monitored voltage with a voltage threshold; and
sending a wake-up signal for power replenishment of the low-voltage battery (120) when the time value is greater than the first time threshold, the value of the state of charge is less than the charge threshold, and the value of the voltage is less than the voltage threshold for a second time threshold.

9. The power replenishment wake-up method (300) according to claim 8, wherein
the power replenishment wake-up method (300) comprises performing state of charge monitoring, voltage monitoring, and timing monitoring simultaneously.

10. The power replenishment wake-up method (300) according to claim 8 or 9, wherein
the second time threshold ranges from 0 to 10 seconds.

11. The power replenishment wake-up method (300) according to any one of claims 8 to 10, wherein
the low-voltage battery (120) is a lithium iron phosphate battery.

12. The power replenishment wake-up method (300) according to any one of claims 8 to 11, wherein
the low-voltage battery (120) comprises a plurality of cells, and the power replenishment wake-up method (300) comprises: monitoring voltages of all of the plurality of cells, respectively comparing the voltages of all of the plurality of cells with the voltage threshold, and sending a wake-up signal for power replenishment of the low-voltage battery (120) when one of the voltages of all of the plurality of cells is less than the voltage threshold for a second time threshold.

13. The power replenishment wake-up method (300) according to any one of claims 8 to 12, wherein
the charge threshold ranges from 50% to 70%, and the first time threshold ranges from 1h to 72h.

14. A vehicle (100), the vehicle (100) comprising a power replenishment wake-up apparatus (130) according to any one of claims 1 to 7.

15. A computer-readable storage medium comprising instructions which, when executed by a computer, cause the computer to carry out the steps of the method according to any of claims 8 to 13.

## Patentansprüche

1. Weckeinrichtung zum Energieaufladen (130) für eine Niederspannungsbatterie (120), wobei die Niederspannungsbatterie (120) in einem Fahrzeug (100) angewandt wird, wobei die Weckeinrichtung zum Energieaufladen (130) umfasst:
eine Zeitmesseinheit (210), wobei die Zeitmesseinheit (210) konfiguriert ist zum: Starten der Zeitmessung, wenn das Fahrzeug (100) in einen Fahrzeugschlafzustand eintritt;
eine Ladeüberwachungseinheit (220), wobei die Ladeüberwachungseinheit (220) konfiguriert ist zum Überwachen eines Ladezustands der Niederspannungsbatterie (120);
eine Spannungsüberwachungseinheit (230), wobei die Spannungsüberwachungseinheit (230) konfiguriert ist zum Überwachen einer Spannung der Niederspannungsbatterie (120); und
eine Vergleichseinheit (240), wobei die Vergleichseinheit (240) mit der Zeitmesseinheit (210), der Ladeüberwachungseinheit (220) bzw. der Spannungsüberwachungseinheit (230) kommunikativ verbunden ist und wobei die Vergleichseinheit (240) konfiguriert ist zum:
Empfangen, von der Zeitmesseinheit (210), eines Werts einer gezählten Zeit, die einen Wert einer akkumulierten Zeit anzeigt, während der sich das Fahrzeug (100) in dem Fahrzeugschlafzustand befunden hat, und Vergleichen des Werts der Zeit mit einem ersten Zeitschwellenwert;
Empfangen eines Werts des Ladezustands von der Ladeüberwachungseinheit (220) und Vergleichen des Werts des Ladezustands mit einem Ladeschwellenwert;
Empfangen eines Werts der Spannung von der Spannungsüberwachungseinheit (230) und Vergleichen des Werts der Spannung mit einem Spannungsschwellenwert; und
Senden eines Wecksignals für ein Energieaufladen der Niederspannungsbatterie (120), wenn die folgenden Vergleichsergebnisse erfüllt sind: der Zeitwert größer als der erste Zeitschwellenwert ist, der Wert des Ladezustands kleiner als der Ladeschwellenwert ist und der Wert der Spannung für einen zweiten Zeitschwellenwert kleiner als der Spannungsschwellenwert ist.

2. Weckeinrichtung zum Energieaufladen (130) nach Anspruch 1, wobei die Weckeinrichtung zum Energieaufladen (130) ferner umfasst:
eine Schalteinheit (250), wobei die Schalteinheit (250) konfiguriert ist, um in der Lage zu sein, eine oder mehrere der Folgenden selektiv ein- oder auszuschalten: die Ladeüberwachungseinheit (220), die Spannungsüberwachungseinheit (220) und die Zeitsteuerungseinheit (210).

3. Weckeinrichtung zum Energieaufladen (130) nach einem der Ansprüche 1 bis 2, wobei
der zweite Zeitschwellenwert zwischen 0 und 10 Sekunden liegt.

4. Weckeinrichtung zum Energieaufladen (130) nach einem der Ansprüche 1 bis 3, wobei
die Niederspannungsbatterie (120) eine Lithium-Eisenphosphat-Batterie ist.

5. Weckeinrichtung zum Energieaufladen (130) nach einem der Ansprüche 1 bis 4, wobei
die Niederspannungsbatterie (120) eine Vielzahl von Zellen umfasst, wobei die Spannungsüberwachungseinheit (230) ferner konfiguriert ist zum Überwachen der Spannungen von allen aus der Vielzahl von Zellen, und wobei die Vergleichseinheit (240) ferner konfiguriert ist zum: sobald die überwachten Spannungen von allen aus der Vielzahl von Zellen von der Spannungsüberwachungseinheit (230) empfangen werden, jeweiliges Vergleichen der Werte der Spannungen von allen aus der Vielzahl von Zellen mit dem Spannungsschwellenwert; und Senden eines Wecksignals zum Energieaufladen der Niederspannungsbatterie (120), wenn mindestens einer der Werte der Spannungen von allen aus der Vielzahl von Zellen für einen zweiten Zeitschwellenwert kleiner als der Spannungsschwellenwert ist.

6. Weckeinrichtung zum Energieaufladen (130) nach einem der Ansprüche 1 bis 5, wobei
der Ladeschwellenwert im Bereich von 50% bis 70% liegt und der erste Zeitschwellen im Bereich von 1h bis 72h liegt.

7. Weckeinrichtung zum Energieaufladen (130) nach einem der Ansprüche 1 bis 6, wobei die Weckeinrichtung zum Energieaufladen (130) ferner umfasst:
eine Schwellenwertzugriffseinheit (260), wobei die Schwellenwertzugriffseinheit (260) mit der Vergleichseinheit (240) kommunikativ verbunden ist und wobei die Schwellenwertzugriffseinheit (260) konfiguriert ist zum: Speichern des Ladeschwellenwerts, des Spannungsschwellenwerts und des ersten Zeitschwellenwerts und Empfangen von Modifikationen an dem Ladeschwellenwert, dem Spannungsschwellen und dem ersten Zeitschwellenwert.

8. Weckverfahren zum Energieaufladen (300) für eine Niederspannungsbatterie (120), wobei die Niederspannungsbatterie (120) in ein Fahrzeug (100) montiert ist, wobei das Weckverfahren zum Energieaufladen (300) umfasst:
Durchführen eines Zeitmessvergleichs (310), eines Ladevergleichs (320) und eines Spannungsvergleichs (330), wobei
der Zeitmessvergleich (310) umfasst: Starten der Zeitmessung, wenn das Fahrzeug (100) in einen Fahrzeugschlafzustand eintritt, und Vergleichen eines Werts einer gezählten Zeit, die einen Wert einer akkumulierten Zeit anzeigt, während der sich das Fahrzeug (100) in dem Fahrzeugschlafzustand befindet, mit einem ersten Zeitschwellenwert;
der Ladevergleich (320) umfasst: Überwachen eines Ladezustands der Niederspannungsbatterie (120) und Vergleichen eines Werts des überwachten Ladezustands mit einem Ladeschwellenwert; und
der Spannungsvergleich (330) umfasst: Überwachen einer Spannung der Niederspannungsbatterie (120) und Vergleichen eines Werts der überwachten Spannung mit einem Spannungsschwellenwert; und
Senden eines Wecksignals für ein Energieaufladen der Niederspannungsbatterie (120), wenn der Zeitwert größer als der erste Zeitschwellenwert ist, der Wert des Ladezustands kleiner als der Ladeschwellenwert ist und der Wert der Spannung für einen zweiten Zeitschwellenwert kleiner als der Spannungsschwellenwert ist.

9. Weckverfahren zum Energieaufladen (300) nach Anspruch 8, wobei
das Weckverfahren zum Energieaufladen (300) ein gleichzeitiges Durchführen einer Ladezustandsüberwachung, einer Spannungsüberwachung und einer Zeitmessüberwachung umfasst.

10. Weckverfahren zum Energieaufladen (300) nach Anspruch 8 oder 9, wobei
der zweite Zeitschwellenwert zwischen 0 und 10 Sekunden liegt.

11. Weckverfahren zum Energieaufladen (300) nach einem der Ansprüche 8 bis 10, wobei
die Niederspannungsbatterie (120) eine Lithium-Eisenphosphat-Batterie ist.

12. Weckverfahren zum Energieaufladen (300) nach einem der Ansprüche 8 bis 11, wobei
die Niederspannungsbatterie (120) eine Vielzahl von Zellen umfasst, und wobei das Weckverfahren zum Energieaufladen (300) umfasst: Überwachen von Spannungen von allen aus der Vielzahl von Zellen, jeweiliges Vergleichen der Spannungen von allen aus der Vielzahl von Zellen mit dem Spannungsschwellenwert, und Senden eines Wecksignals zum Energieaufladen der Niederspannungsbatterie (120), wenn eine der Spannungen von allen aus der Vielzahl von Zellen für einen zweiten Zeitschwellenwert kleiner als der Spannungsschwellenwert ist.

13. Weckverfahren zum Energieaufladen (300) nach einem der Ansprüche 8 bis 12, wobei
der Ladeschwellenwert im Bereich von 50% bis 70% liegt und der erste Zeitschwellen im Bereich von 1h bis 72h liegt.

14. Fahrzeug (100), wobei das Fahrzeug (100) eine Weckeinrichtung zum Energieaufladen (130) nach einem der Ansprüche 1 bis 7 umfasst.

15. Computerlesbares Speichermedium, das Anweisungen umfasst, die, wenn sie von einem Computer ausgeführt werden, veranlassen, dass der Computer die Schritte des Verfahrens nach einem der Ansprüche 8 bis 13 ausführt.

## Revendications

1. Appareil de réveil de réapprovisionnement en énergie (130) pour une batterie basse tension (120), la batterie basse tension (120) étant appliquée à un véhicule (100), l'appareil de réveil de réapprovisionnement en énergie (130) comprenant :
une unité de mesure du temps (210), l'unité de mesure du temps (210) étant configurée pour : démarrer le mesure du temps lorsque le véhicule (100) entre dans un état de sommeil du véhicule ;
une unité de surveillance de charge (220), l'unité de surveillance de charge (220) étant configurée pour surveiller un état de charge de la batterie basse tension (120) ;
une unité de surveillance de tension (230), l'unité de surveillance de tension (230) étant configurée pour contrôler une tension de la batterie basse tension (120) ; et
une unité de comparaison (240), l'unité de comparaison (240) étant connectée de manière communicante respectivement à l'unité de mesure du temps (210), à l'unité de surveillance de charge (220) et à l'unité de surveillance de tension (230), et l'unité de comparaison (240) étant configurée pour :
recevoir, de l'unité de mesure du temps (210), la valeur d'un temps compté indiquant une valeur de temps cumulé pendant lequel le véhicule (100) a été dans l'état de sommeil du véhicule, et comparer la valeur de temps à un premier seuil de durée ;
recevoir une valeur de l'état de charge de l'unité de surveillance de charge (220), et comparer la valeur de l'état de charge à un seuil de charge ;
recevoir une valeur de la tension de l'unité de surveillance de tension (230), et comparer la valeur de la tension à un seuil de tension ; et
envoyer un signal de réveil pour réapprovisionnement en énergie de la batterie basse tension (120) lorsque les résultats de comparaison suivants sont satisfaits : la valeur de temps est supérieure au premier seuil de temps, la valeur de l'état de charge est inférieure au seuil de charge, et la valeur de la tension est inférieure au seuil de tension pendant un deuxième seuil de temps.

2. Appareil de réveil de réapprovisionnement en énergie (130) selon la revendication 1, dans lequel l'appareil de réveil de réapprovisionnement en énergie (130) comprend en outre :
une unité de commutation (250), l'unité de commutation (250) étant configurée pour pouvoir sélectivement activer ou désactiver un ou plusieurs des éléments suivants : l'unité de surveillance de charge (220), l'unité de surveillance de tension (220) et l'unité de mesure du temps (210).

3. Appareil de réveil de réapprovisionnement en énergie (130) selon l'une quelconque des revendications 1 et 2, dans lequel
le deuxième seuil de temps est compris entre 0 et 10 secondes.

4. Appareil de réveil de réapprovisionnement en énergie (130) selon l'une quelconque des revendications 1 à 3, dans lequel
la batterie basse tension (120) est une batterie au batterie au lithium-fer-phosphate.

5. Appareil de réveil de réapprovisionnement en énergie (130) selon l'une quelconque des revendications 1 à 4, dans lequel
la batterie basse tension (120) comprend une pluralité de cellules, l'unité de surveillance de tension (230) est en outre configurée pour surveiller des tensions de l'ensemble de la pluralité de cellules, et l'unité de comparaison (240) est en outre configurée pour : à la réception, de l'unité de surveillance de tension (230), des tensions surveillées de l'ensemble de la pluralité de cellules, comparer respectivement des valeurs des tensions de l'ensemble de la pluralité de cellules au seuil de tension ; et envoyer un signal de réveil pour un réapprovisionnement en énergie de la batterie basse tension (120) lorsqu'au moins une des valeurs des tensions de l'ensemble des cellules de la pluralité de cellules est inférieure au seuil de tension pendant un deuxième seuil de durée.

6. Appareil de réveil de réapprovisionnement en énergie (130) selon l'une quelconque des revendications 1 à 5, dans lequel
le seuil de charge est dans la plage de 50 % à 70 %, et le premier seuil de durée est dans la plage de 1 h à 72 h.

7. Appareil de réveil de réapprovisionnement en énergie (130) selon l'une quelconque des revendications 1 à 6, dans lequel l'appareil de réveil de réapprovisionnement en énergie (130) comprend en outre :
une unité d'accès aux seuils (260), l'unité d'accès aux seuils (260) étant connectée en communication avec l'unité de comparaison (240), et l'unité d'accès aux seuils (260) étant configurée pour : stocker le seuil de charge, le seuil de tension et le premier seuil de temps, et recevoir des modifications du seuil de charge, du seuil de tension et du premier seuil de temps.

8. Procédé de réveil (300) de réapprovisionnement en énergie pour une batterie basse tension (120), la batterie basse tension (120) étant montée sur un véhicule (100), le procédé de réveil (300) de réapprovisionnement en énergie comprenant les étapes suivantes :
réaliser une comparaison de mesure du temps (310), une comparaison de charge (320) et une comparaison de tension (330), où
la comparaison de mesure du temps (310) comprend : le démarrage de la mesure du temps lorsque le véhicule (100) entre dans un état de veille du véhicule, et la comparaison de la valeur d'un temps compté indiquant une valeur de temps accumulé pendant lequel le véhicule (100) a été dans l'état de veille du véhicule avec un premier seuil de temps ;
la comparaison de charge (320) comprend : la surveillance d'un état de charge de la batterie basse tension (120), et la comparaison d'une valeur de l'état de charge surveillé avec un seuil de charge ; et
la comparaison de tension (330) comprend : la surveillance d'une tension de la batterie basse tension (120), et la comparaison d'une valeur de la tension surveillée à un seuil de tension ; et
envoyer un signal de réveil pour le réapprovisionnement en énergie de la batterie basse tension (120) lorsque la valeur de temps est supérieure au premier seuil de temps, la valeur de l'état de charge est inférieure au seuil de charge, et la valeur de la tension est inférieure au seuil de tension pendant un deuxième seuil de temps.

9. Procédé de réveil de réapprovisionnement en énergie (300) selon la revendication 8, dans lequel le procédé (300) de réveil de réapprovisionnement en énergie comprend d'effectuer simultanément une surveillance de l'état de charge, une surveillance de la tension et une surveillance de la mesure du temps.

10. Procédé de réveil de réapprovisionnement en énergie (300) selon la revendication 8 ou la revendication 9, dans lequel
le deuxième seuil de temps est compris entre 0 et 10 secondes.

11. Procédé de réveil de réapprovisionnement en énergie (300) selon l'une quelconque des revendications 8 à 10, dans lequel
la batterie basse tension (120) est une batterie au batterie au lithium-fer-phosphate.

12. Procédé de réveil de réapprovisionnement en énergie (300) selon l'une quelconque des revendications 8 à 11, dans lequel
la batterie basse tension (120) comprend une pluralité de cellules, et le procédé de réveil de réapprovisionnement en énergie (300) comprend les étapes suivantes : surveiller les tensions de l'ensemble de la pluralité de cellules, comparer respectivement les tensions de l'ensemble de la pluralité de cellules avec le seuil de tension, et envoyer un signal de réapprovisionnement en énergie de la batterie basse tension (120) lorsque l'une des tensions de l'ensemble de la pluralité de cellules est inférieure au seuil de tension pendant un deuxième seuil de temps.

13. Procédé de réveil de réapprovisionnement en énergie (300) selon l'une quelconque des revendications 8 à 12, dans lequel
le seuil de charge est dans la plage de 50 % à 70 %, et le premier seuil de durée est dans la plage de 1 h à 72 h.

14. Véhicule (100), le véhicule (100) comprenant un appareil de réveil de réapprovisionnement en énergie (130) selon l'une quelconque des revendications 1 à 7.

15. Support de stockage lisible par ordinateur comprenant des instructions qui, lorsqu'elles sont exécutées par un ordinateur, amènent l'ordinateur à exécuter les étapes du procédé selon l'une quelconque des revendications 8 à 13.
